# EUROPEAN PATENT APPLICATION

(11) **EP 4 391 779 A1**
(43) Date of publication of application: **26.06.2024**
(21) Application number: 23218615.5
(22) Date of filing: 20.12.2023
(51) Int. Cl.: H10K 59/80, H10K 71/16, H10K 71/00

(54) **ELECTROLUMINESCENT DISPLAY DEVICE**

(30) Priority: 22.12.2022 KR 20220181700
(71) Applicant: LG Display Co., Ltd., Seoul 07336 (KR)
(72) Inventor: CHA, Eonho, 10845 Paju-si, Gyeonggi-do (KR); HAN, GyuHyeong, 10845 Paju-si, Gyeonggi-do (KR); IM, HunBae, 10845 Paju-si, Gyeonggi-do (KR); LEE, Yoonseok, 10845 Paju-si, Gyeonggi-do (KR); YEO, Jonghoon, 10845 Paju-si, Gyeonggi-do (KR)
(74) Representative: Viering, Jentschura & Partner mbB Patent- und Rechtsanwälte

(57) **Abstract**

An electroluminescent display device includes a substrate (101) including an active area (AA) and a non-active area (NA) surrounding the active area (AA); a planarization layer (105) over the substrate (101); an anode (151) on the planarization layer (105); an organic layer (152) on the anode (151) and absent at a laser ablation area (LA) in the non-active area (NA) to surround the active area (AA), a portion of the organic layer (152) disposed outside the laser ablation area (LA); a cathode (153) on the organic layer (152) and absent at the laser ablation area (LA), a portion of the cathode (153) disposed outside the laser ablation area (LA); an encapsulation substrate (109, 309) above the substrate (101); and a dam (140, 240, 340) at the laser ablation area (LA) between the substrate (101) and the encapsulation substrate (109, 309).

## Description

### CROSS-REFERENCE TO RELATED APPLICATIONS

This application claims the benefit of and priority to Korean Patent Application No. 10-2022-0181700 filed on December 22, 2022, in the Republic of Korea.

### BACKGROUND

### Technical Field

The present disclosure relates to an electroluminescent display device, and more particularly, to an electroluminescence display device that can be manufactured in various sizes.

### Discussion of the Related Art

As our society has advanced toward an information-oriented society, the field of display devices for visually expressing an electrical information signal has rapidly advanced. Various display devices having excellent performance in terms of thinness, lightness, and low power consumption are being developed correspondingly.

Representative display devices include a liquid crystal display device (LCD), an electro-wetting display device (EWD), and an organic light emitting display device (OLED). Among the display devices, an electroluminescent display device, such as the organic light emitting display device, is a self-luminous display device and can be manufactured to be light and thin because it does not require a separate light source, unlike the liquid crystal display device, which has a separate light source. In addition, the electroluminescent display device has advantages in terms of power consumption due to low voltage driving. The electroluminescent display device also excels in terms of a color implementation, a response speed, a viewing angle, and a contrast ratio (CR). Therefore, electroluminescent display devices have been expected to be used in various application fields.

### SUMMARY

Accordingly, embodiments of the present disclosure are directed to an electroluminescent display device that substantially obviates one or more of the problems due to limitations and disadvantages of the related art.

An aspect of the present disclosure is to provide an electroluminescent display device having a display panel that can be manufactured in various sizes.

Another aspect of present disclosure is to provide an electroluminescent display device capable of preventing moisture penetration at a side surface thereof.

Additional features and aspects will be set forth in the description that follows, and in part will be apparent from the description, or may be learned by practice of the inventive concepts provided herein. Other features and aspects of the inventive concepts may be realized and attained by the structure particularly pointed out in the written description, or derivable therefrom, and the claims hereof as well as the appended drawings.

To achieve these and other aspects of the inventive concepts, as embodied and broadly described herein, an electroluminescent display device comprises a substrate including an active area and a non-active area surrounding the active area; a planarization layer over the substrate; an anode on the planarization layer; an organic layer on the anode and absent at a laser ablation area in the non-active area to surround the active area, a portion of the organic layer disposed outside the laser ablation area; a cathode on the organic layer and absent at the laser ablation area, a portion of the cathode disposed outside the laser ablation area; an encapsulation substrate above the substrate; and a dam at the laser ablation area between the substrate and the encapsulation substrate.

In another aspect, An electroluminescent display device comprises a substrate including an active area and a non-active area surrounding the active area; an anode over the substrate in at least the active area; an organic layer on the anode in at least the active area; a cathode on the organic layer in at least the active area; wherein a laser ablation area is defined in the non-active area to surround the active area, wherein each of the organic layer and the cathode are absent in the laser ablation area, and wherein at least one of the organic layer and the cathode is disposed in the non-active area outside of the laser ablation area.

In another aspect, an electroluminescent display device comprises a substrate including an active area and a non-active area surrounding the active area; an anode on the substrate in at least the active area; an organic layer on the anode, the organic layer being divided into a first portion at least in the active area, and a second portion in the non-active area; a cathode on the organic layer and is divided into two portions in the active area and in the non-active area, respectively; and a dam disposed in a laser ablation area which is disposed between the first and second portions of the organic layer.

According to the present disclosure, by selectively scribing the other side of a mother substrate opposite to one side thereof on which a printed circuit board is disposed, various models can be produced through manufacturing display panels of various sizes, and defective display panels can be recycled, thereby improving a product yield.

In the present disclosure, before scribing the mother substrate, an organic layer and a cathode at an inside of a scribe line are selectively removed through laser ablation, and a dam containing getter elements is filled therein, so that it is possible to prevent moisture penetration into a side surface of a display device and improve reliability thereof.

It is to be understood that both the foregoing general description and the following detailed description are exemplary and explanatory and are intended to provide further explanation of the inventive concepts as claimed.

### BRIEF DESCRIPTION OF THE DRAWINGS

The accompanying drawings, which are included to provide a further understanding of the disclosure and are incorporated in and constitute a part of this application, illustrate embodiments of the disclosure and together with the description serve to explain various principles.
FIG. 1 is a plan view of an electroluminescent display device according to an example embodiment of the present disclosure.
FIG. 2 is a plan view exemplarily illustrating a scribing process of the electroluminescent display device according to an example embodiment of the present disclosure.
FIG. 3 is a cross-sectional view taken along Ia-Ia' of FIG. 1.
FIG. 4 is a cross-sectional view taken along Ib-Ib' of FIG. 1.
FIGs. 5A to 5F are cross-sectional views sequentially illustrating parts of a manufacturing process of the electroluminescent display device according to an example embodiment of the present disclosure.
FIG. 6 is a cross-sectional view of an electroluminescent display device according to another example embodiment of the present disclosure.
FIG. 7 is a cross-sectional view of an electroluminescent display device according to still another example embodiment of the present disclosure.

### DETAILED DESCRIPTION

Advantages and characteristics of the present disclosure and a method of achieving the advantages and characteristics will be clear by referring to example embodiments described below in detail together with the accompanying drawings. However, the present disclosure is not limited to the example embodiments disclosed herein but will be implemented in various forms. The example embodiments are provided by way of example only so that those skilled in the art can fully understand the disclosures of the present disclosure and the scope of the present disclosure.

The shapes, sizes, ratios, angles, numbers, and the like illustrated in the accompanying drawings for describing the example embodiments of the present disclosure are merely examples, and the present disclosure is not limited thereto. Like reference numerals generally denote like elements throughout the specification. Further, in the following description of the present disclosure, a detailed explanation of known related technologies may be omitted to avoid unnecessarily obscuring the subject matter of the present disclosure. Terms such as "including," "having," and "consist of" used herein are generally intended to allow other components to be added unless the terms are used with the term "only." Any references to singular may include plural unless expressly stated otherwise.

Components are interpreted to include an ordinary error range even if not expressly stated.

When the position relation between two parts is described using the terms such as "on," "above," "below," and "next," one or more parts may be positioned between the two parts unless the terms are used with the term "immediately" or "directly."

When an element or layer is disposed "on" another element or layer, another layer or another element may be interposed directly on the other element or therebetween.

Although the terms "first," "second," and the like are used for describing various components, these components are not confined by these terms. These terms are merely used for distinguishing one component from the other components. Therefore, a first component to be mentioned below may be a second component in a technical concept of the present disclosure.

Like reference numerals generally denote like elements throughout the specification.

A size and a thickness of each component illustrated in the drawing are illustrated for convenience of description, and the present disclosure is not limited to the size and the thickness of the component illustrated.

The features of various embodiments of the present disclosure can be partially or entirely adhered to or combined with each other and can be interlocked and operated in technically various ways, and the embodiments can be carried out independently of or in association with each other.

Hereinafter, example embodiments of the present disclosure will be described in detail with reference to accompanying drawings.

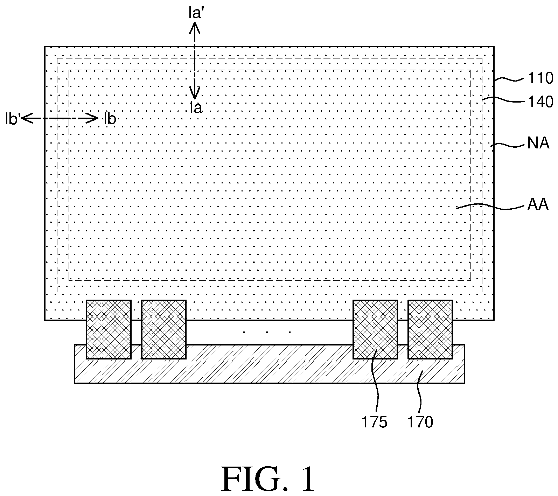

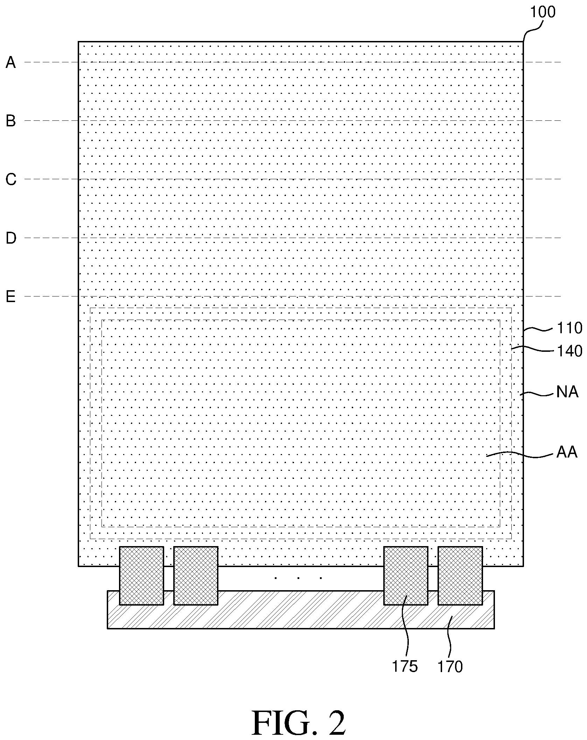

FIG. 1 is a plan view of an electroluminescent display device according to an example embodiment of the present disclosure. FIG. 2 is a plan view exemplarily illustrating a scribing process of the electroluminescent display device according to an example embodiment of the present disclosure.

FIG. 2 exemplarily illustrates a scribing (or cutting) process for manufacturing display panels 110 in various sizes on a mother substrate 100 having a large area.

With reference to FIGs. 1 and 2, an electroluminescent display device according to an example embodiment of the present disclosure may include the display panel 110, flexible films 175, a printed circuit board 170, and a dam 140.

The display panel 110 is a panel for displaying an image to a user. The display panel 110 may include a display element for displaying an image, a driving element for driving the display element, and lines for transmitting various signals to the display element and the driving element. The display element may be defined differently depending on a type of display panel 110. For example, when the display panel 110 is an organic light emitting display panel, the display element may be an organic light emitting element including an anode, an organic light emitting layer, and a cathode. For example, when the display panel 110 is a liquid crystal display panel, the display element may be a liquid crystal display element.

Hereinafter, it is assumed that the display panel 110 is an organic light emitting display panel, but the display panel 110 is not limited to the organic light emitting display panel.

The display panel 110 may include an active area AA and a non-active area NA. The active area AA is an area where an image is displayed on the display panel 110.

A plurality of sub-pixels constituting a plurality of pixels and circuits for driving the plurality of sub-pixels may be disposed in the active area AA. The plurality of sub-pixels are minimum units constituting the active area AA, and a display element may be disposed in each of the plurality of sub-pixels, and the plurality of sub-pixels may constitute pixels. For example, an organic light emitting element including an anode, an organic layer, and a cathode may be disposed in each of the plurality of sub-pixels, but the present disclosure is not limited thereto. In addition, the circuit for driving the plurality of sub-pixels may include driving elements and lines. For example, the circuit may include thin film transistors, a storage capacitor, gate lines, data lines, and the like, but the present disclosure is not limited thereto.

The non-active area NA is an area in which an image is not displayed. Although FIG. 1 illustrates that the non-active area NA surrounds the active area AA having a rectangular shape, shapes and arrangements of the active area AA and the non-active area NA are limited to an example shown in FIG. 1.

For example, the active area AA and the non-active area NA may have shapes suitable for a design of an electronic apparatus in which an electroluminescent display device is mounted. For example, the active area AA may have, for example a pentagonal shape, a hexagonal shape, a circular shape, or an elliptical shape.

In the non-active area NA, various lines and circuits for driving the organic light emitting elements of the active area AA may be disposed. For example, in the non-active area NA, driver ICs, such as a gate driver IC and a data driver IC, or link lines for transmitting signals to the plurality of sub-pixels and circuits of the active area AA may be disposed, but the present disclosure is not limited thereto.

The electroluminescent display device may include various additional elements for generating various signals or driving the pixels in the active area AA. The additional elements for driving the pixels may include an inverter circuit, a multiplexer, an electrostatic discharge (ESD) circuit, and the like. The electroluminescent display device may also include additional elements related to functions other than pixel driving. For example, the electroluminescent display device may further include additional elements that provide a touch sensing function, a user authentication function (e.g., fingerprint recognition), a multi-level pressure sensing function, a tactile feedback function, and the like. The aforementioned additional elements may be located in the non-active area NA and/or in an external circuit connected to a connection interface.

The flexible film 175 is a film in which various parts are disposed on a flexible base film. Specifically, the flexible film 175 is a film for supplying signals to the plurality of sub-pixels and circuits of the active area AA, and may be electrically connected to the display panel 110. The flexible film 175 may be disposed on one end of the non-active area NA in the display panel 110 and supply power voltages, data voltages, and the like to the plurality of sub-pixels and circuits of the active area AA. The number of flexible films 175 may be variously changed according to design.

Meanwhile, the driver ICs, such as a gate driver IC and a data driver IC, may be disposed on the flexible film 175. The driver IC is a component that processes data for displaying an image and a driving signal for processing the image. The driver IC may be disposed in a method, such as a chip on glass (COG) method, a chip on film (COF) method, or a tape carrier package (TCP) method depending on a mounting method.

The printed circuit board 170 may be disposed on one end of the flexible film 175 and connected to the flexible film 175. For example, the printed circuit board 170 is a component that supplies signals to the driver IC. The printed circuit board 170 may supply various signals, such as driving signals and data signals to the driver IC. For example, a data driver for generating data signals may be mounted on the printed circuit board 170, and the generated data signals may be supplied to the plurality of sub-pixels and circuits of the display panel 110 through the flexible films 175. The number of printed circuit boards 170 may be variously changed according to design, but the present disclosure is not limited thereto.

Meanwhile, in accordance with FIG. 2, the display panels 110 may be manufactured in various sizes by selectively scribing the other side of the mother substrate 100 opposite to one side thereof on which the printed circuit board 170 is disposed. For example, the display panels 110 of desired sizes can be manufactured by selectively scribing the mother substrate 100 along a plurality of pre-scribing lines A, B, C, D, and E formed on the other side of the mother substrate 100. Here, FIG. 1 illustrates, for example, a case where the other side of the mother substrate 100 is cut along pre-scribing line E in FIG. 2, but the present disclosure is not limited thereto.

Therefore, according to the present disclosure, various models can be produced by manufacturing the display panels 110 of various sizes, and defective display panels can be recycled, thereby improving a product yield. For example, when the display panel 110 is manufactured by scribing the mother substrate 110 along pre-scribing line B in FIG. 2 but is discarded due to a defect occurring during a process, for example, when a defective portion that has occurred is located between pre-scribing line B and pre-scribing line C, the display panel 110 can be recycled by scribing the mother substrate 100 again along pre-scribing line C, D, or E.

Meanwhile, for this purpose, the electroluminescent display device of the present disclosure is characterized in that the plurality of sub-pixels and portions of the circuits are formed in an area ranging from pre-scribing line A to pre-scribing line E of the mother substrate 100, in the same manner as in the active area AA. For example, the plurality of sub-pixels in which the organic light emitting elements are disposed, and portions of the circuits, such as thin film transistors, storage capacitors, gate lines, and data lines, may be provided in the area ranging from pre-scribing line A to pre-scribing line E of the mother substrate 100, in the same manner as in the active area AA. Also, in an area ranging from pre-scribing line E to the non-active area NA on the other side of the display panel 110, the plurality of sub-pixels in which the organic light emitting elements are disposed, and portions of the circuits, such as thin film transistors, storage capacitors, gate lines, and data lines, may be provided in the same manner as in the active area AA.

Meanwhile, in the present disclosure, because the plurality of sub-pixels and portions of the circuits are formed on the other side of the display panel 110 in the same manner as in the active area AA, the other side of the display panel 110 is exposed to the outside by scribing and is vulnerable to moisture.

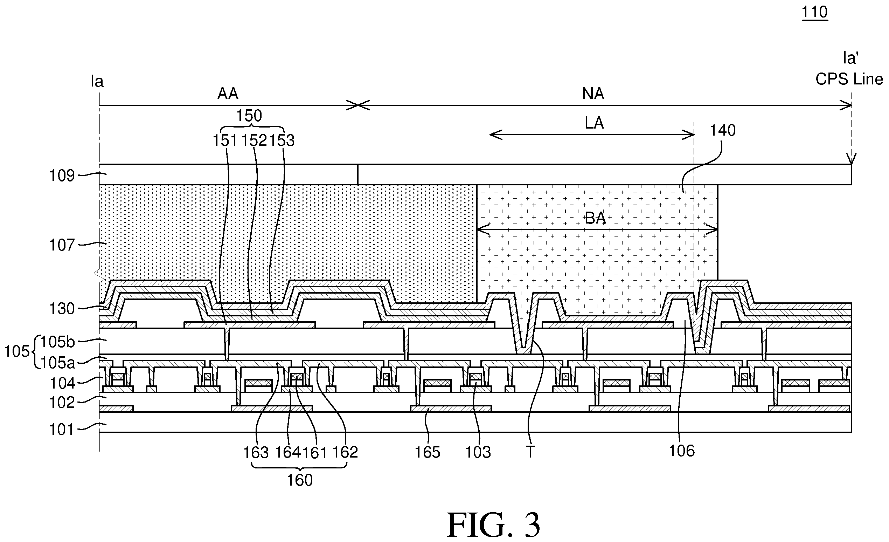

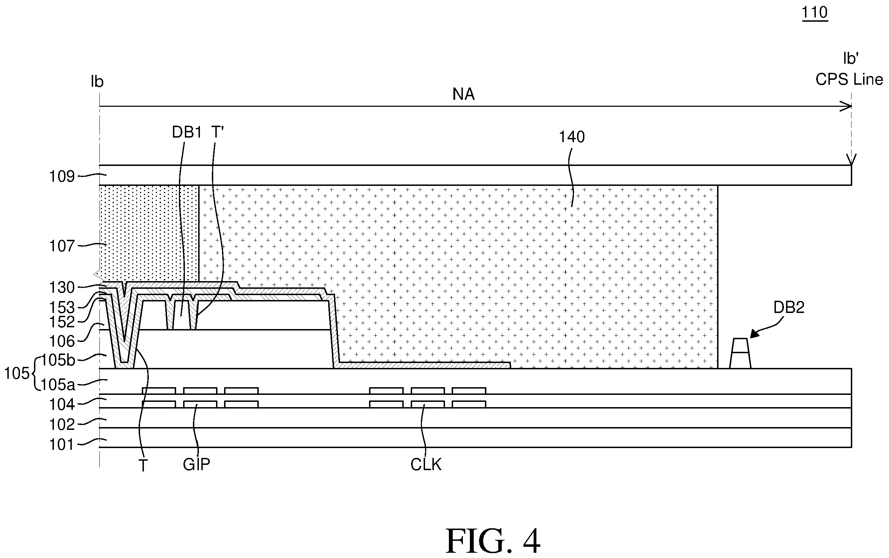

Accordingly, before scribing the mother substrate 100, the organic layer and the cathode of the non-active area NA at an inside of pre-scribing line E may be selectively removed through laser ablation, and the dam 140 containing getter elements is filled therein so that it is possible to prevent moisture penetration into a side surface of the display device and improve reliability thereof. This will be described in detail with reference to cross-sectional views of FIGs. 3 and 4.

FIG. 3 is a cross-sectional view taken along Ia-Ia' of FIG. 1. FIG. 4 is a cross-sectional view taken along Ib-Ib' of FIG. 1. FIG. 3 shows a cross-section of the other side, for example, an upper side, of the display panel 110 shown in FIG. 1, and FIG. 4 shows a cross-section of a left side of the display panel 110 shown in FIG. 1 as an example. FIG. 4 schematically illustrates GIP circuits GIP and clock lines CLK in the non-active area NA for convenience of description.

Right ends of FIGs. 3 and 4 may coincide with scribe line CPS Line where the mother substrate is cut.

As illustrated in FIGs. 3 and 4, in the display panel 110 according to an example embodiment of the present disclosure, driving elements 160 may be disposed on a substrate 101.

In addition, a planarization layer 105 may be disposed on the driving elements 160.

In addition, an organic light emitting element 150 that is electrically connected to the driving element 160 is disposed on the planarization layer 105, and a passivation layer 130 may be disposed on the organic light emitting element 150 to prevent oxygen and moisture from permeating into the organic light emitting element 150.

An adhesive layer 107 and an encapsulation substrate 109 may be sequentially disposed on the passivation layer 130. However, the present disclosure is not limited to such a laminated structure.

The substrate 101 may be a glass or plastic substrate. When the substrate 101 is a plastic substrate, a polyimide-based or polycarbonate-based material may be used to have flexibility. In particular, polyimide can be applied to a high-temperature process and is widely used as a plastic substrate because it is a material that can be coated. A buffer layer 102 may be disposed on the substrate 101.

The buffer layer 102 is a layer for protecting various electrodes and lines from impurities, such as alkali ions, flowing out from the substrate 101 or lower layers thereof, and may have a multilayer structure including a first buffer layer and a second buffer layer. However, the present disclosure is not limited thereto. The buffer layer 102 may be formed of silicon oxide (SiOx) or silicon nitride (SiNx) or a multilayer thereof.

The buffer layer 102 may delay diffusion of moisture and/or oxygen penetrating into the substrate 101. The buffer layer 102 may include a multi-buffer and/or an active buffer. The active buffer protects an active layer 164 formed of a semiconductor of the driving element 160 and may perform a function of blocking various types of defects introduced from the substrate 101. The active buffer may be formed of amorphous silicon (a-Si) or the like.

Alight blocking layer 165 may be disposed between the substrate 101 and the buffer layer 102. The light blocking layer 165 may be disposed to overlap the active layer 164 of the driving element 160. The light blocking layer 165 may be formed of molybdenum (Mo), aluminum (Al), copper (Cu), titanium (Ti), or a multilayer thereof. For example, the light blocking layer 165 may have a multilayer structure of Ti/Al/Ti. The light blocking layer 165 may be disposed to overlap the active layer 164 formed of an oxide semiconductor. Because the active layer 164 formed of an oxide semiconductor has characteristics that are vulnerable to light, the light blocking layer 165 can prevent element characteristics of the driving element 160 from being changed due to leakage current occurring in the active layer 164 that is caused by external light incident from a bottom of the substrate 101. In addition, the light blocking layer 165 may be connected to a drain electrode 163. For example, although FIG. 3 shows that the light blocking layer 165 is connected to the drain electrode 163, the light blocking layer 165 may be connected to a source electrode 162.

The driving element 160 may be disposed on the buffer layer 102. The driving element 160 may include the active layer 164, a gate electrode 161, the source electrode 162, and the drain electrode 163, and may be electrically connected to the organic light emitting element 150 through a connection electrode (not shown) to transmit a current or signal to the organic light emitting element 150.

The active layer 164 may be located over the buffer layer 102. The active layer 164 may be formed of polysilicon (p-Si), and in this case, a predetermined region thereof may be doped with impurities. In addition, the active layer 164 may be formed of amorphous silicon (a-Si) or may be formed of various organic semiconductor materials, such as pentacene, and the like. The active layer 164 may also be formed of an oxide semiconductor.

A gate insulating layer 103 may be located between the active layer 164 and the gate electrode 161. The gate insulating layer 103 may be formed of an insulating inorganic material, such as silicon oxide (SiOx) or silicon nitride (SiNx), and in addition to this, it may be formed of an insulating organic material or the like.

The gate electrode 161 may be disposed on the gate insulating layer 103. The gate electrode 161 may be formed of various conductive materials, such as magnesium (Mg), aluminum (Al), nickel (Ni), chromium (Cr), molybdenum (Mo), tungsten (W), gold (Au), or an alloy thereof.

An interlayer insulating layer 104 may be disposed on the gate electrode 161. In this case, the interlayer insulating layer 104 may be formed of an insulating material, such as silicon oxide (SiOx) or silicon nitride (SiNx), and in addition to this, it may be formed of an insulating organic material or the like. By selectively removing the interlayer insulating layer 104, contact holes for exposing a source region and a drain region of the active layer 164 may be formed. The source electrode 162 and the drain electrode 163 may be formed of an electrode material in a single-layer or multilayer structure on the interlayer insulating layer 104. If necessary or desired, an additional passivation layer formed of an inorganic insulating material may be formed to cover the source electrode 162 and the drain electrode 163.

The planarization layer 105 may be disposed on the driving elements 160 configured as described above.

Meanwhile, the GIP circuits GIP and the clock lines CLK may be disposed above the substrate 101 in the non-active area NA on left and right sides of the display panel 110. FIG. 4 schematically illustrates the GIP circuits GIP and the clock lines CLK for convenience of description, but the present disclosure is not limited thereto.

In addition, the driving element 160 may be disposed in the non-active area NA located on the upper side of the display panel 110 in the same manner as in the active area AA. Here, the upper side of the display panel 110 means a side portion where the scribe line CPS Line is located and scribing is performed, and as described above, it means a side portion opposite to a lower side of the display panel 110 where the printed circuit board is disposed. For example, the planarization layer 105 may be configured as a single layer. However, the present disclosure is not limited thereto, and the planarization layer 105 may have a multilayer structure including at least two layers. In this case, for example, as shown in FIGs. 3 and 4, the planarization layer 105 may include a first planarization layer 105a and a second planarization layer 105b. The first planarization layer 105a may be disposed to cover the driving element 160 and may be disposed to expose a portion of the drain electrode 163 of the driving element 160.

The planarization layer 105 may extend to the non-active area NA to cover the GIP circuits GIP. For example, the first planarization layer 105a may be disposed on an entire surface of the substrate 101. In addition, the second planarization layer 105b may extend to the non-active area NA, for example, to an end portion of the substrate 101 on which the scribe line CPS Line is formed, on the upper side of the display panel 110. On the other hand, the second planarization layer 105b may extend to a portion of the non-active area NA on the left and right sides of the display panel 110. For example, the second planarization layer 105b may extend to a portion of the non-active area NA on the left and right sides of the display panel 110 so as to cover the GIP circuits GIP. Accordingly, the second planarization layer 105b may not be disposed in the other portions of the non-active area NA on the left and right sides of the display panel 110, so that the first planarization layer 105a may be exposed, but the present disclosure is not limited thereto. In addition, the second planarization layer 105b may extend to a portion of the non-active area NA or extend to the end portion of the substrate 101 on the lower side of the display panel 110.

The planarization layer 105 may have a thickness of about 2 µm, but is not limited thereto. The planarization layer 105 may be an overcoat layer, but is not limited thereto.

A trench pattern T (herein after "trench T") may be formed by removing a portion of the second planarization layer 105b, and may serve to block or retard moisture penetration from the outside. The trench T may be formed to expose an upper surface of the first planarization layer 105a, therebelow. The trench T may be formed in a direction parallel to a pre-scribing line, for example, the scribe line CPS Line, but is not limited thereto. The trench T may be disposed at a boundary between the sub-pixels adjacent to each other, but is not limited thereto. The trench T may be disposed in a direction parallel to an edge of the substrate 101 in the non-active area NA. The trench T may be disposed in the direction parallel to a boundary between the active area AA and the non-active area NA.

Although not shown, a connection electrode for electrically connecting the driving element 160 and the organic light emitting element 150 may be disposed on the first planarization layer 105a. In addition, various metal layers serving as lines/electrodes for data lines and signal lines may be disposed on the first planarization layer 105a.

In the display panel 110 according to an example embodiment of the present disclosure, the planarization layer 105 is formed of two layers due to an increase of various signal lines as the display panel 110 has a higher resolution. Accordingly, an additional layer is formed because it is difficult to place all the lines on one layer while securing a minimum distance therebetween. Due to the addition of such an additional layer, for example, the second planarization layer 105b, a margin is created in line arrangement, and line/electrode arrangement design can be further facilitated. In addition, when a dielectric material is used for the planarization layer 105 formed of multiple layers, the planarization layer 105 may also be used for forming capacitance between metal layers.

The second planarization layer 105b may be formed to expose a portion of the connection electrode, and the drain electrode 163 of the driving element 160 and an anode 151 of the organic light emitting element 150 may be electrically connected by the connection electrode.

The organic light emitting element 150 may be configured by sequentially disposing the anode 151, a plurality of organic layers 152, and a cathode 153. For example, the organic light emitting element 150 may include the anode 151 formed on the planarization layer 105, the organic layer 152 formed on the anode 151, and the cathode 153 formed on the organic layer 152.

Meanwhile, in the present disclosure, the organic light emitting element 150 having a structure described above may also be disposed in the non-active area NA on the upper side of the display panel 110. However, the organic light emitting element 150 disposed in the non-active area NA on the upper side of the display panel 110 may be irrelevant to driving.

The electroluminescent display device may be implemented in a top emission method or bottom emission method. In the case of the top emission method, a reflective layer formed of an opaque conductive material having high reflectivity, such as silver (Ag), aluminum (Al), gold (Au), molybdenum (Mo), tungsten (W), chromium (Cr), or an alloy thereof, may be added under the anode 151 such that light emitted from the organic layer 152 is reflected by the anode 151 and directed upward, for example, in a direction toward the cathode 153 located thereabove. On the other hand, in the case of the bottom emission method, the anode 151 may be formed of only a transparent conductive material, such as indium tin oxide (ITO), indium zinc oxide (IZO), or indium gallium zinc oxide (IGZO). Hereinafter, descriptions will be made on the assumption that the display panel 110 of the present disclosure is in the top emission method.

A bank 106 may be disposed on the planarization layer 105 in an area other than an emission area. The bank 106 may have a bank hole exposing the anode 151 corresponding to the emission area. The bank 106 may be formed of an inorganic insulating material, such as silicon nitride (SiNx) or silicon oxide (SiOx), or an organic insulating material, such as BCB, acrylic resin, or imide resin.

The bank 106 may extend to the non-active area NA. For example, the bank 106 may also be formed in a portion of the non-active area NA on the upper side of the display panel 110 and may extend to a portion of the non-active area NA on the left and right sides and the lower side of the display panel 110. For example, the bank 106 may extend into the non-active area NA, up to an end portion of the second planarization layer 105b on the left and right sides and the lower side of the display panel 110.

The bank 106 may have a thickness of about 1 µm, but is not limited thereto. The bank 106 may cover upper portions of the GIP circuits GIP, but is not limited thereto.

A plurality of additional trenches T' may be formed through the planarization layer 105 at an edge of the laser ablation area LA by removing portions of the bank 106. For example, for example, the bank 106 may be removed from portions of the non-active area NA located on the left and right sides and the lower side of the display panel 110 to thereby form a plurality of additional trenches T'. The additional trenches T' may be formed to expose an upper surface of the second planarization layer 105b, therebelow.

In this case, a portion of the bank 106 disposed between the plurality of additional trenches T' may be referred to as a first dam bank DB1. The additional trenches T' and the first dam bank DB1 may be disposed adjacent to an inside of the dam 140.

Also, a second dam bank DB2 composed of the bank 106 and the second planarization layer 105b may be disposed outside the dam 140. The second dam bank DB2 may be disposed adjacent to the outside of the dam 140. The second dam bank DB2 may be disposed in the non-active area NA on the left and right sides and the lower side of the display panel 110, except for the upper side thereof.

The organic layer 152 may be disposed on the anode 151 that is exposed by the bank 106. The organic layer 152 may include a light emitting layer, an electron injection layer, an electron transport layer, a hole transport layer, a hole injection layer, and the like. The organic layer 152 may extend to the non-active area NA.

In the non-active area NA, the organic layer 152 may be disposed on the bank 106. For example, a portion of the organic layer 152 may be disposed outside of a laser ablation area LA. The laser ablation area LA may be in the non-active area NA to surround the active area AA. The organic layer 152 may be divided into a first portion at least in the active area AA, and a second portion in the non-active area NA. The laser ablation area LA may be disposed between the first and second portions of the organic layer 152.

For example, the organic layer 152 may be disposed on the bank 106 and the anode 151 in the non-active area NA except for the laser ablation area LA. In addition, the organic layer 152 may be disposed within the trench T except for the laser ablation area LA. Also, the organic layer 152 may be disposed within the additional trench T'. The organic layer 152 may be absent at portions of the additional trench T' within the laser ablation area LA.

On the upper side of the display panel 110, the organic layer 152 may be disposed up to the end portion of the substrate 101 on which the scribe line CPS Line is formed, but may be removed and short-circuited in the laser ablation area LA, so that penetration of moisture introduced from the outside can be blocked.

The cathode 153 may be disposed on the organic layer 152. In the non-active area NA, the cathode 153 may be disposed on the organic layer 152.

For example, the cathode 153 may be disposed up to the outside of the laser ablation area LA. A portion of the cathode 153 may be disposed outside of the laser ablation area LA. Further, the cathode 153 may be disposed on the organic layer 152 in the non-active area NA except for the laser ablation area LA.

On the upper side of the display panel 110, the cathode 153 may be disposed up to the end portion of the substrate 101 on which the scribe line CPS Line is formed, but may be removed and short-circuited in the laser ablation area LA, so that penetration of moisture introduced from the outside can be blocked.

The cathode 153 may be disposed to cover the organic layer 152 in the non-active area NA on the left and right sides and the lower side of the display panel 110. The cathode 153 may extend to the non-active area NA to cover a side surface of the organic layer 152 in the non-active area NA on the left and right sides and the lower side of the display panel 110. The organic layer 152 may be spaced apart from an end portion of the cathode 153 by a predetermined distance, but is not limited thereto.

The cathode 153 may be disposed within the trench T except for the laser ablation area LA. In addition, the cathode 153 may also be disposed within the additional trench T', but is not limited thereto. The cathode 153 may be absent at portions of the additional trench T' within the laser ablation area LA. The laser ablation area LA may be an area from which the cathode 153 and the organic layer 152 are removed by irradiating a laser to a portion of the upper side of the non-active area NA.

In the case of the top emission method, the cathode 153 may include a transparent conductive material. For example, the cathode 153 may be formed of indium tin oxide (ITO), indium zinc oxide (IZO), or indium gallium zinc oxide (IGZO). In the case of the bottom emission method, the cathode 153 may include any one of metal materials, such as gold (Au), silver (Ag), aluminum (Al), molybdenum (Mo), magnesium (Mg), palladium (Pd), and copper (Cu), or alloys thereof. Alternatively, the cathode 153 may be configured by stacking a layer formed of a transparent conductive material, such as indium tin oxide (ITO), indium zinc oxide (IZO), or indium gallium zinc oxide (IGZO), and a layer formed of a metal material, such as gold (Au), silver (Ag), aluminum (Al), molybdenum (Mo), magnesium (Mg), palladium (Pd), copper (Cu), or an alloy thereof, but is not limited thereto.

Meanwhile, although not shown, a capping layer formed of a material having a high refractive index and high light absorption may be disposed on the organic light emitting element 150 to reduce diffused reflection of external light. The capping layer may be an organic material layer, and may be omitted if necessary.

The capping layer may extend to the non-active area NA except for the laser ablation area LA. In the non-active area NA, the capping layer may be disposed on the cathode 153.

For example, on the upper side of the display panel 110, the capping layer may be disposed up to the end portion of the substrate 101 on which the scribe line CPS Line is formed, but may be removed and short-circuited in the laser ablation area LA, so that penetration of moisture introduced from the outside can be blocked.

In addition, the capping layer may be disposed on the cathode 153 in the non-active area NA on the left and right sides and the lower side of the display panel 110. The capping layer may be disposed within the trench T except for the laser ablation area LA, but is not limited thereto.

The display panel 110 according to an example embodiment of the present disclosure may include the laser ablation area LA from which the capping layer, the cathode 153, and the organic layer 152 are removed. The laser ablation area LA may be disposed in the non-active area NA on the upper side of the display panel 110. The laser ablation area LA may be spaced apart from the scribe line CPS Line or an edge of the substrate 101 by a predetermined distance in consideration of a process margin.

The laser ablation area LA refers to an area from which the capping layer, the cathode 153 and the organic layer 152 of the non-active area NA on the upper side of the display panel 110 are removed through laser ablation, for example. However, the present disclosure is not limited thereto, and the bank 106 and the second planarization layer 105b, and the anode 151 under the organic layer 152 may be removed therefrom.

Also, the laser ablation area LA may include at least one trench T. For example, at least one trench T is disposed in the laser ablation area LA. As the capping layer, the cathode 153, and the organic layer 152 are removed, a side surface of the second planarization layer 105b within the trench T and the upper surface of the first planarization layer 105a therebelow may be exposed. Meanwhile, the passivation layer 130 may be disposed on the cathode 153 as well as on the laser ablation area LA.

The passivation layer 130 may extend to the non-active area NA. The passivation layer 130 may be disposed to cover the GIP circuits GIP and the clock lines CLK in the non-active area NA on the left and right sides of the display panel 110. For example, the passivation layer 130 may extend to the non-active area NA to contact a portion of the upper surface of the first planarization layer 105a over the clock lines CLK, while covering the cathode 153, the bank 106, and the side surface of the second planarization layer 105b above the GIP circuits GIP in the non-active area NA on the left and right sides of the display panel 110.

In addition, the passivation layer 130 may be disposed up to the end portion of the substrate 101 on which the scribe line CPS Line is formed, on the upper side of the display panel 110. Also, the passivation layer 130 may also be disposed within the trench T in the laser ablation area LA from which the capping layer, the cathode 153, and the organic layer 152 are removed. The passivation layer 130 may be formed of silicon oxide (SiOx), silicon nitride (SiNx), or a multilayer thereof to retard moisture permeation, but the present disclosure is not limited thereto.

The adhesive layer 107 and the encapsulation substrate 109 may be disposed on the passivation layer 130.

The adhesive layer 107 may be disposed on the passivation layer 130. The adhesive layer 107 and the encapsulation substrate 109 may extend to the non-active area NA. For example, the adhesive layer 107 may extend to a side surface of the dam 140, and the encapsulation substrate 109 may extend to the scribe line CPS Line.

In this case, the adhesive layer 107, together with the capping layer, the passivation layer 130 and the encapsulation substrate 109, may protect the organic light emitting element 150 in the active area AA from external moisture, oxygen, impacts, and the like.

The adhesive layer 107 may further include a moisture absorbent. The moisture absorbent may include particles having hygroscopicity, for example, fillers, and may absorb moisture and oxygen from the outside, thereby minimizing penetration of moisture and oxygen into the organic light emitting element 150.

The filler may be formed of a transparent material to prevent a decrease in luminance when light emitted from the organic light emitting element 150 is transmitted through the encapsulation substrate 109. For example, the filler may be formed of epoxy or olefin, and may include talc, calcium oxide (CaO), barium oxide (BaO), zeolite, silicon oxide (SiO), and the like.

The encapsulation substrate 109 may be disposed on the adhesive layer 107. The encapsulation substrate 109 may protect the organic light emitting element 150 together with the adhesive layer 107. The encapsulation substrate 109 may protect the organic light emitting element 150 from external moisture, oxygen, impacts, and the like.

The dam 140 may be disposed between the substrate 101 and the encapsulation substrate 109 at an edge of the substrate 101 to reinforce adhesion between the substrate 101 and the encapsulation substrate 109 and block moisture.

The dam 140 may be disposed in the non-active area NA outside the active area AA. For example, the dam 140 is formed to surround the active area AA on a plane view, and may seal it by bonding the substrate 101 and the encapsulation substrate 109 together with the adhesive layer 107.

The dam 140 may include a sealant and fillers dispersed in the sealant. The sealant may be a heat curable or ultraviolet (UV) curable sealant.

For example, the sealant may be selected as an epoxy-based or acrylic-based sealant to which a thermal curing accelerator and/or a photo-initiator are added. However, the present disclosure is not limited thereto.

The sealant may bond edges of the substrate 101 and the encapsulation substrate 109 to reinforce adhesion between them. The filler may be formed of a material capable of absorbing moisture, and may be pulverized into small sizes and uniformly dispersed in the sealant.

The filler is not limited to a specific material, but may be formed of, for example, alkali-metal oxide, silica, porous zeolite, and other organic or inorganic moisture absorbents. A moisture-reactive adsorbent may include one of metal powder, such as alumina, metal oxide, metal salts, or phosphorus pentoxide (P₂O₅) or a mixture of two or more kinds thereof, and a physical adsorbent may include silica, zeolite, titania, zirconia, or montmorillonite, or the like.

The dam 140 may further include a spacer.

The spacer is not limited to a specific material, but may be formed of, for example, a glass fiber, a silicon oxide (SiO²) rod or powder, or a carbon material. The spacer can be processed to have a size larger than that of the filler and dispersed in the sealant.

The spacer may limit a gap between the substrate 101 and the encapsulation substrate 109 within the dam 140. Accordingly, the spacer can prevent collapse of the dam 140 due to pressure when the substrate 101 and the encapsulation substrate 109 are bonded.

The dam 140 may further include getters. In this case, the getters may include at least one of barium oxide (BaO), calcium oxide (CaO), magnesium oxide (MgO), magnesium sulfate (MgSO₄), sodium oxide (Na₂O), sodium sulfate (Na₂SO₄), lithium sulfate (LiSO), calcium sulfate (CaSO₄), potassium oxide (K₂O), lithium oxide (Li₂O), gallium sulfate (GaS), calcium chloride (CaCl²), magnesium chloride (MgCl₂), calcium bromide (CaBr₂), cerium bromide (CsBr), vanadium bromide (VBrs) and calcium nitrate (Ca(NO₃)₂). The getters may be formed of particles having a size of about 50 to 100 nm.

Meanwhile, in the non-active area NA on the upper side of the display panel 110, the laser ablation area LA is located in a reliable bezel area BA where the dam 140 is disposed. For example, the laser ablation area LA is located within the reliable bezel area BA and has a width smaller than that of the reliable bezel area BA.

Hereinafter, a manufacturing process of the electroluminescent display device will be described in detail with reference to the drawings.

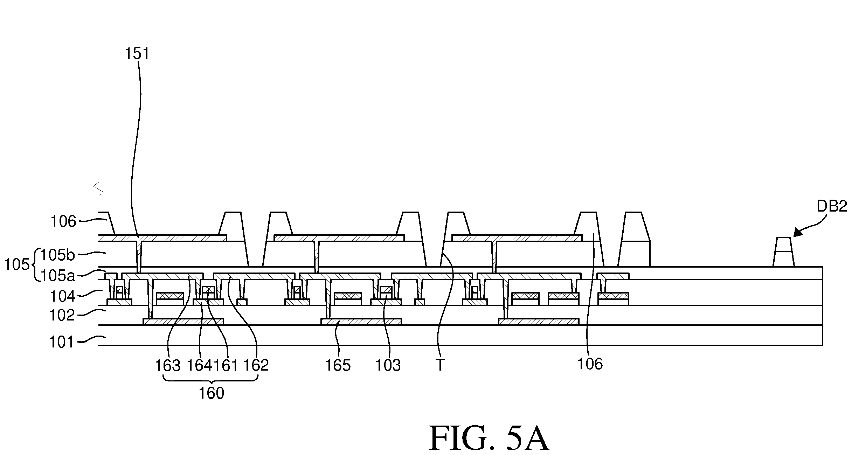

FIGs. 5A to 5F are cross-sectional views sequentially illustrating parts of a manufacturing process of the electroluminescent display device according to an example embodiment of the present disclosure. FIGs. 5A to 5F sequentially show, for example, parts of a manufacturing process of the upper side of the display panel.

First, with reference to FIG. 5A, various components of a pixel unit are formed on the substrate 101. As described above, the pixel unit is formed in an active area of the substrate 101, but in the present disclosure, the pixel unit may also be formed in a non-active area on the upper side of the display panel. Also, although not shown, a GIP unit including various components may be formed in the non-active area of the substrate 101 except for the upper side of the display panel. Specifically, the substrate 101 may be a glass or plastic substrate.

The light blocking layer 165 may be formed on the substrate 101. The light blocking layer 165 may be formed to overlap the active layer 164 of the driving element 160. The light blocking layer 165 may be formed of molybdenum (Mo), aluminum (Al), copper (Cu), titanium (Ti), or multiple layers thereof.

The buffer layer 102 may be formed on the light blocking layer 165. The buffer layer 102 may have a multilayer structure including a first buffer layer and a second buffer layer, but is not limited thereto. The buffer layer 102 may be formed of silicon oxide (SiOx), silicon nitride (SiNx), or multiple layers thereof.

The driving element 160 may be formed on the buffer layer 102.

First, the active layer 164 may be formed on the buffer layer 102. The active layer 164 may be formed of polysilicon. In addition, the active layer 164 may be formed of amorphous silicon (a-Si), or may be formed of various organic semiconductor materials, such as pentacene and the like. The active layer 164 may be formed of an oxide semiconductor. The gate electrode 161 may be formed on the active layer 164 with the gate insulating layer 103 interposed therebetween.

The gate insulating layer 103 may be formed of an insulating inorganic material, such as silicon oxide (SiOx) or silicon nitride (SiNx), or may be formed of an insulating organic material or the like.

The gate electrode 161 may be formed of various conductive materials, such as magnesium (Mg), aluminum (Al), nickel (Ni), chromium (Cr), molybdenum (Mo), tungsten (W), and gold (Au), or alloys thereof.

The interlayer insulating layer 104 may be formed on the gate electrode 161. The interlayer insulating layer 104 may be formed of an insulating material, such as silicon oxide (SiOx) or silicon nitride (SiNx), and in addition to this, it may be formed of an insulating organic material or the like.

Contact holes for exposing the source and drain regions of the active layer 164 may be formed by selectively removing the interlayer insulating layer 104. The source electrode 162 and the drain electrode 163 may be formed on the interlayer insulating layer 104.

The source electrode 162 and the drain electrode 163 may be electrically connected to the source region and the drain region of the active layer 164 through the contact holes, respectively.

Meanwhile, although not shown, GIP circuits and clock lines may be formed above the substrate 101 in the non-active area on left and right sides of the display panel. The GIP circuit and the clock line may be formed together with the driving element 160 during a process of forming the driving element 160 in the active area.

The first planarization layer 105a may be formed on the driving element 160 configured as described above. The first planarization layer 105a may be formed on the entire surface of the substrate 101.

The second planarization layer 105b may be formed on the first planarization layer 105a. The second planarization layer 105b may be formed to be spaced apart from the end portion of the substrate 101 by a predetermined distance on the upper side of the display panel, and may extend to a portion of the non-active area on the left and right sides of the display panel.

Although not shown, a connection electrode for electrically connecting the driving element 160 and the organic light emitting element 150 may be formed on the first planarization layer 105a. In this case, the second planarization layer 105b may be formed to expose a portion of the connection electrode, and the drain electrode 163 of the driving element 160 therebelow and the anode 151 of the organic light emitting element 150 may be electrically connected by the connection electrode.

The organic light emitting element 150 may be configured by sequentially disposing the anode 151, the plurality of organic layers 152, and the cathode 153. The anode 151 may be formed on the second planarization layer 105b. The anode 151 may be over the substrate 101 in at least the active area AA. The organic layer 152 may be on the anode 151 in at least the active area AA. The cathode 153 may be on the organic layer 152 in at least the active area AA.

In the case of the top emission method, a reflective layer formed of an opaque conductive material having high reflectivity, such as silver (Ag), aluminum (Al), gold (Au), molybdenum (Mo), tungsten (W), chromium (Cr), or an alloy thereof, may be added under the anode 151 such that light emitted from the organic layer 152 is reflected by the anode 151 and directed upward, for example, in a direction toward the cathode 153 located thereabove.

The bank 106 may be formed in a remaining area other than an emission area on the second planarization layer 105b. For example, the bank 106 has a bank hole exposing the anode 151 corresponding to the emission area. The bank 106 may be formed of an inorganic insulating material, such as silicon nitride (SiNx) or silicon oxide (SiOx) or an organic insulating material, such as BCB, acrylic resin, or imide resin.

The bank 106 may extend to the non-active area NA. For example, the bank 106 may also be formed in a portion of the non-active area on the upper side of the display panel, and may extend to a portion of the non-active area on the left and right sides and lower side of the display panel.

At this time, the second dam bank DB2 composed of the bank 106 and the second planarization layer 105b may be formed at the edge of the substrate 101.

Meanwhile, the trench T may be formed by removing portions of the bank 106 and the second planarization layer 105b. The trench T may be formed to expose the upper surface of the first planarization layer 105a, therebelow. The trench T may be formed at a boundary between the sub-pixels adjacent to each other, but is not limited thereto.

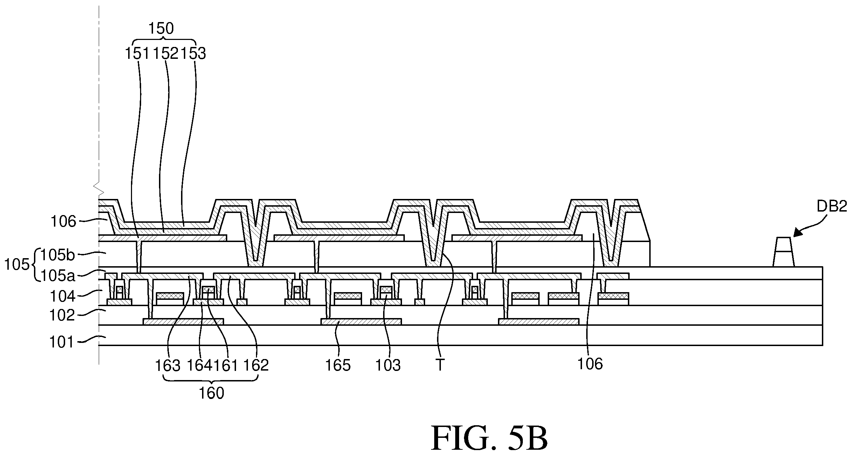

Next, as shown in the example of FIG. 5B, the organic layer 152 may be formed on the anode 151 that is exposed by the bank 106. The organic layer 152 may include a light emitting layer, an electron injection layer, an electron transport layer, a hole transport layer, a hole injection layer, and the like.

The organic layer 152 may extend to the non-active area. In the non-active area, the organic layer 152 may be formed on the bank 106. The organic layer 152 may also be formed within the trench T. The cathode 153 may be formed on the organic layer 152. In the non-active area, the cathode 153 may be formed on the organic layer 152.

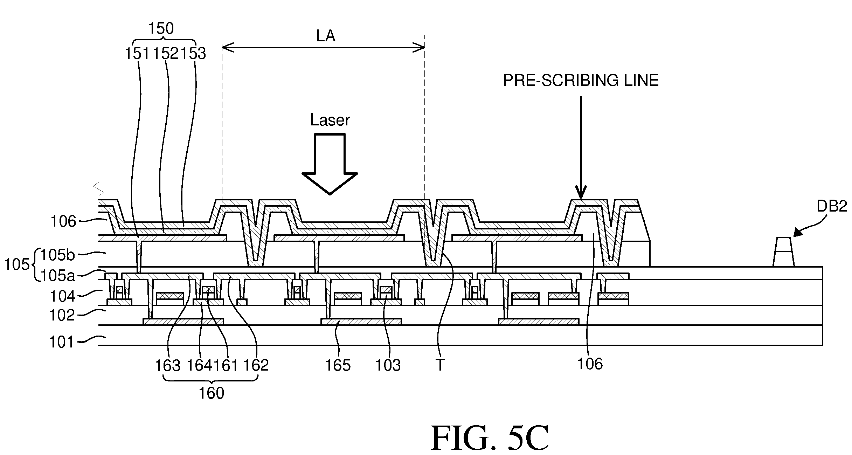

Then, in FIG. 5C, when the display panel having a desired size is determined, the cathode 153 and the organic layer 152 within the laser ablation area LA may be removed by performing laser ablation on a predetermined area of the substrate 101 formed as a mother substrate, for example, the laser ablation area LA. However, the present disclosure is not limited thereto, and the bank 106 and the second planarization layer 105b, and the anode 151 under the organic layer 152 may also be removed.

The laser ablation used to remove the cathode 153 and the organic layer 152 has an advantage in that no seam occurs in the passivation layer 130 to be deposited later. On the other hand, although an undercut structure can be formed by wet etching, the passivation layer 130 does not completely cover an undercut region, and a seam may occur.

The laser ablation area LA may be located within a predetermined distance from a pre-scribing line in consideration of a process margin. The laser ablation area LA may be disposed in the non-active area on the upper side of the display panel.

The laser ablation area LA may include at least one trench T. The at least one trench T is disposed in the laser ablation area LA. As the cathode 153 and the organic layer 152 are removed therefrom, the side surface of the second planarization layer 105b within the trench T and the upper surface of the first planarization layer 105a therebelow may be exposed.

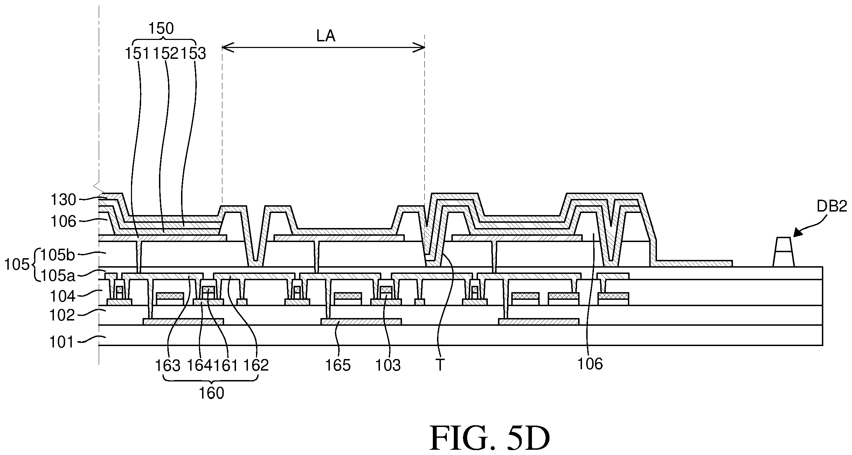

Next, as illustrated in FIG. 5D, the passivation layer 130 may be formed on the cathode 153 as well as on the laser ablation area LA. The passivation layer 130 may extend to the non-active area NA.

The passivation layer 130 may also be formed within the trench T in the laser ablation area LA from which the cathode 153 and the organic layer 152 are removed. The passivation layer 130 is formed on the cathode 153, but in the laser ablation area LA, may be formed on the bank 106 and the anode 151 as well as on an inside of the trench T and may come into contact with a portion of the anode 151 and the bank 106. In addition, the passivation layer 130 may extend to the end portion of the substrate 101 while covering side surfaces of the bank 106 and the second planarization layer 105b on the upper side of the display panel. The passivation layer 130 may be formed of silicon oxide (SiOx), silicon nitride (SiNx), or a multilayer thereof to retard moisture penetration.

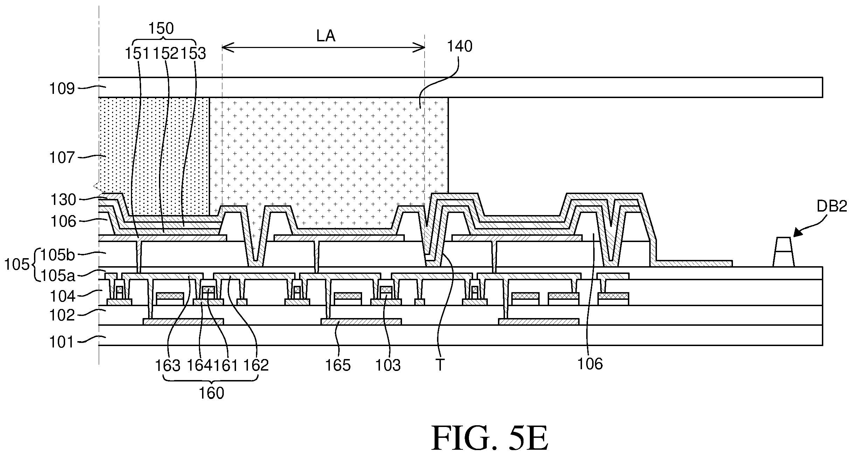

Subsequently, with reference to FIG. 5E, the dam 140 may be formed by applying a dam material including getters to a predetermined region of the encapsulation substrate 109 manufactured in another process.

The dam 140 may be disposed in the non-active area outside the active area. For example, the dam 140 may be formed to surround the active area on a plane.

Meanwhile, on the upper side of the active area, the dam 140 may be disposed on an upper surface of the encapsulation substrate 109 corresponding to the laser ablation area LA of the substrate 101. The dam 140 may include a sealant and fillers dispersed in the sealant. The sealant may be a heat curable or ultraviolet (UV) curable sealant.

The dam 140 may further include a spacer. The spacer is not limited to a specific material, but may be formed of, for example, a glass fiber, a silicon oxide (SiO²) rod or powder, or a carbon material. The spacer can be processed to have a size larger than that of the filler and dispersed in the sealant.

The dam 140 may further include getters.

The adhesive layer 107 may be applied to the inside of the dam 140, and the substrate 101 and the encapsulation substrate 109 may be vacuum-bonded. For example, the adhesive layer 107 may extend to the side surface of the dam 140. The adhesive layer 107 may further include a moisture absorbent. The moisture absorbent may include particles having hygroscopicity, for example, fillers.

In this case, the dam 140 may contact an upper surface of the passivation layer 130 above the substrate 101 simultaneously with contacting the upper surface of the encapsulation substrate 109, but the present disclosure is not limited thereto. Thereafter, a heat curing process or UV curing process may be performed.

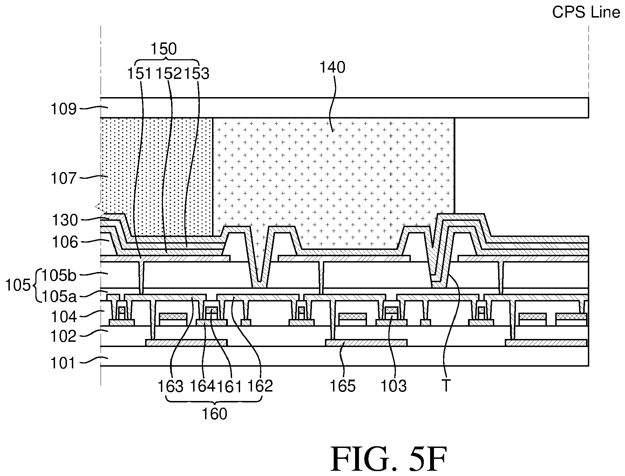

Next, as illustrated in FIG. 5F, the display panel may be separated from the mother substrate by performing scribing along scribe line CPS Line.

The scribe line CPS Line may be spaced apart from the laser ablation area LA by a predetermined distance in consideration of a process margin. As described above, on the upper side of the display panel because the same pixel structure as in the active area is provided even at the scribe line CPS Line, side surfaces of some components of the driving element 160 may be exposed by the scribe line CPS Line.

Further, on the upper side of the display panel, the passivation layer 130, the cathode 153, the organic layer 152, the anode 151, the second planarization layer 105b, and the first planarization layer 105a may extend to the end portion of the substrate 101 on which the scribe line CPS Line is formed. Accordingly, side surfaces of the passivation layer 130, the cathode 153, the organic layer 152, the anode 151, the second planarization layer 105b, and the first planarization layer 105a may also be exposed by the scribe line CPS Line. However, in the laser ablation area LA, the capping layer, the cathode 153, and the organic layer 152 are removed, and a portion of the second planarization layer 105b is removed to form a trench T. By filling the inside of the trench T with the dam 140 containing getter elements, it is possible to prevent moisture from penetrating into the side surface of the display device and improve reliability thereof.

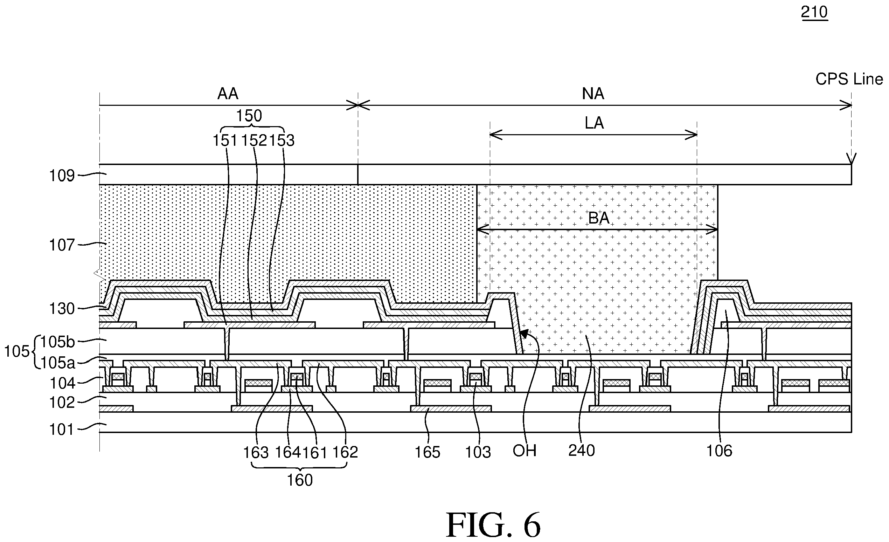

Meanwhile, as described above, during laser ablation, not only the cathode 153 and the organic layer 152, but also the bank 106, anode 151, and the second planarization layer 105b therebelow can be removed together, which will be described in detail with reference to FIG. 6.

FIG. 6 is a cross-sectional view of an electroluminescent display device according to another example embodiment of the present disclosure. FIG. 6 is a cross-sectional view showing an upper side of a display panel 210 according to another example embodiment of the present disclosure.

Because other configurations of the display panel 210 according to another example embodiment of the present disclosure shown in FIG. 6 are substantially the same as those of the display panel 110 according to an example embodiment of the present disclosure shown in FIG. 3 only with a difference in a configuration inside the laser ablation area LA, duplicate descriptions will be omitted.

With reference to FIG. 6, in the display panel 210 according to another example embodiment of the present disclosure, the driving elements 160 may be disposed on the substrate 101. In addition, the planarization layer 105 may be disposed on the driving elements 160.

In addition, the organic light emitting element 150 that is electrically connected to the driving element 160 may be disposed on the planarization layer 105, and the passivation layer 130 may be disposed on the organic light emitting element 150. The adhesive layer 107 and the encapsulation substrate 109 may be sequentially disposed on the passivation layer 130. However, the present disclosure is not limited to such a laminated structure.

In this case, as described above, the driving element 160 may be disposed in the non-active area NA on an upper side of the display panel 210 in the same manner as in the active area AA. Here, the upper side of the display panel 210 refers to a side portion where scribe line CPS Line is located and scribing is performed and refers to a side portion opposite to a lower side of the display panel 210 where a printed circuit board is disposed.

In addition, the planarization layer 105 may have a multilayer structure including at least two layers, and among the at least two layers, the first planarization layer 105a may be disposed to cover the driving element 160. The first planarization layer 105a may be disposed on the entire surface of the substrate 101. Also, the second planarization layer 105b may extend to the end portion of the substrate 101 on which the scribe line CPS Line is formed, on the upper side of the display panel 210.

Meanwhile, in the present disclosure, the organic light emitting element 150 having a structure described above may also be disposed in the non-active area NA on the upper side of the display panel 210. However, the organic light emitting element 150 disposed in the non-active area NA on the upper side of the display panel 210 may be irrelevant to driving.

The bank 106 may be formed on the planarization layer 105 in an area other than an emission area. The bank 106 may extend to the non-active area NA. For example, the bank 106 may also be formed in a portion of the non-active area NA on the upper side of the display panel 210, but is not limited thereto.

The organic layer 152 may be disposed on the anode 151 that is exposed by the bank 106. The organic layer 152 may extend to the non-active area NA.

In the non-active area NA, the organic layer 152 may be disposed on the bank 106. For example, the organic layer 152 may be disposed on the bank 106 and the anode 151 in the non-active area NA except for the laser ablation area LA.

On the upper side of the display panel 210, the organic layer 152 may be disposed up to the end portion of the substrate 101 on which the scribe line CPS Line is formed, but may be removed and short-circuited in the laser ablation area LA, so that penetration of moisture introduced from the outside can be blocked.

The cathode 153 may be disposed on the organic layer 152. In the non-active area NA, the cathode 153 may be disposed on the organic layer 152. For example, the cathode 153 may be disposed on the organic layer 152 in the non-active area NA except for the laser ablation area LA.

On the upper side of the display panel 210, the cathode 153 may be disposed up to the end portion of the substrate 101 on which the scribe line CPS Line is formed, but is removed and short-circuited in the laser ablation area LA, so that penetration of moisture introduced from the outside can be blocked. The display panel 210 according to another example embodiment of the present disclosure may include the laser ablation area LA from which not only the capping layer, the cathode 153, and the organic layer 152 but also the bank 106, the anode 151, and the second planarization layer 105b are removed together. The laser ablation area LA may be disposed in the non-active area NA on the upper side of the display panel 210.

The laser ablation area LA may be spaced apart from the scribe line CPS Line by a predetermined distance in consideration of a process margin. The laser ablation area LA may include, for example, an open hole OH in which not only the capping layer, the cathode 153, and the organic layer 152 of the non-active area NA on the upper side of the display panel 210, but also the bank 106, the anode 151, and the second planarization layer 105b therebelow are removed through laser ablation.

For example, the open hole OH exposing the upper surface of the first planarization layer 105a therebelow is disposed in the laser ablation area LA. As the capping layer, the cathode 153, the organic layer 152, the bank 106, the anode 151, and the second planarization layer 105b are removed from the open hole OH, the side surface of the second planarization layer 105b within the open hole OH and the upper surface of the first planarization layer 105a therebelow may be exposed.

Meanwhile, the passivation layer 130 may be disposed on the cathode 153 as well as on the laser ablation area LA. The passivation layer 130 may extend to the non-active area NA.

The passivation layer 130 may be disposed up to the end portion of the substrate 101 on which the scribe line CPS Line is formed, on the upper side of the display panel 210. Also, the passivation layer 130 may be disposed within the open hole OH in the laser ablation area LA from which the capping layer, the cathode 153, the organic layer 152, the bank 106, the anode 151, and the second planarization layer 105b are removed. The passivation layer 130 may be formed of silicon oxide (SiOx), silicon nitride (SiNx), or a multilayer thereof to retard moisture penetration, but the present disclosure is not limited thereto.

The adhesive layer 107 and the encapsulation substrate 109 may be disposed on the passivation layer 130. The adhesive layer 107 may be disposed on the passivation layer 130. The adhesive layer 107 may extend to a side surface of a dam 240. The encapsulation substrate 109 may be disposed on the adhesive layer 107.

The dam 240 may be disposed between the substrate 101 and the encapsulation substrate 109 at the edge of the substrate 101. The dam 240 may be disposed in the non-active area NA outside the active area AA.

Meanwhile, in the non-active area NA on the upper side of the display panel 210, the laser ablation area LA is located in a reliable bezel area BA where the dam 240 is disposed. For example, the laser ablation area LA is located within the reliable bezel area BA and has a width smaller than that of the reliable bezel area BA.

The dam 240 includes getter elements and is formed to fill the open hole OH of the laser ablation area LA, so that it is possible to prevent moisture penetration into a side surface of the display device and improve reliability thereof.

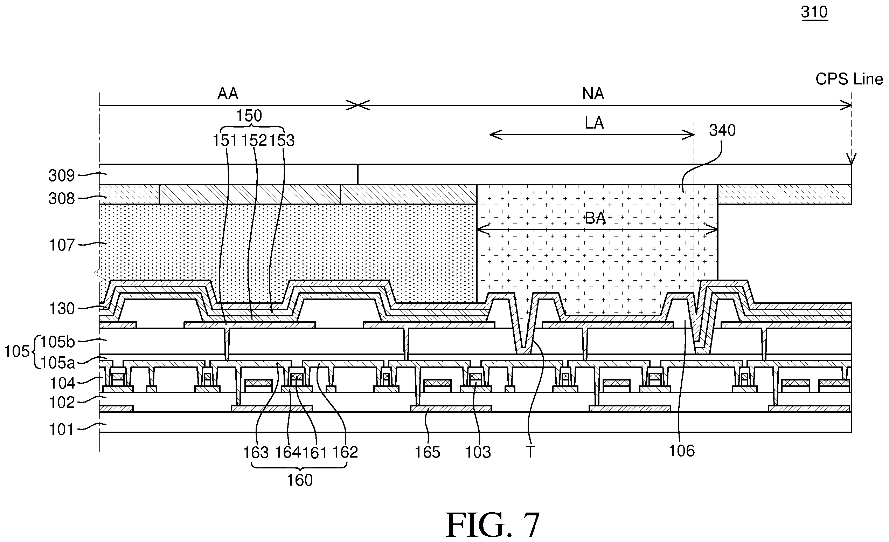

Meanwhile, the present disclosure may further include a color filter layer on the encapsulation substrate 109 positioned in an upper portion of the display panel. In this case, the color filter layer may be removed in the reliable bezel area BA, which will be described in detail with reference to FIG. 7.

FIG. 7 is a cross-sectional view of an electroluminescent display device according to still another example embodiment of the present disclosure.

FIG. 7 is a cross-sectional view showing an upper side of a display panel 310 according to still another example embodiment of the present disclosure. Because other configurations of the display panel 310 according to still another example embodiment of the present disclosure shown in FIG. 7 are substantially the same as those of the display panel 110 according to an example embodiment of the present disclosure shown in FIG. 3 only with a difference in a configuration in a color filter layer 308, duplicate descriptions will be omitted.

With reference to FIG. 7, in the display panel 310 according to still another example embodiment of the present disclosure, the driving elements 160 may be disposed on the substrate 101. In addition, the planarization layer 105 may be disposed on the driving elements 160.

In addition, the organic light emitting element 150 that is electrically connected to the driving element 160 may be disposed on the planarization layer 105, and the passivation layer 130 may be disposed on the organic light emitting element 150.

The adhesive layer 107 and an encapsulation substrate 309 may be sequentially disposed on the passivation layer 130. However, the present disclosure is not limited to such a laminated structure.

In this case, as described above, the driving element 160 may be disposed in the non-active area NA on an upper side of the display panel 310 in the same manner as in the active area AA. In addition, in the present disclosure, the organic light emitting element 150 having a structure described above may be disposed in the non-active area NA on the upper side of the display panel 310. However, the organic light emitting element 150 disposed in the non-active area NA on the upper side of the display panel 310 may be irrelevant to driving.

The display panel 310 according to still another example embodiment of the present disclosure may include a laser ablation area LA from which the capping layer, the cathode 153, and the organic layer 152 are removed, as in the aforementioned example embodiment of the present disclosure. The laser ablation area LA may be disposed in the non-active area NA on the upper side of the display panel 310.

The laser ablation area LA may be spaced apart by a predetermined distance from the scribe line CPS Line in consideration of a process margin. The laser ablation area LA refers to an area in which the capping layer, the cathode 153 and the organic layer 152 of the non-active area NA on the upper side of the display panel 310 are removed through laser ablation, for example. However, the present disclosure is not limited thereto, and the bank 106 and the second planarization layer 105b, and the anode 151 under the organic layer 152 may be removed as in the aforementioned other embodiments of the present disclosure.

Also, the laser ablation area LA may include at least one trench T. For example, at least one trench T is disposed in the laser ablation area LA. As the capping layer, the cathode 153, and the organic layer 152 are removed, the side surface of the second planarization layer 105b within the trench T and the upper surface of the first planarization layer 105a therebelow may be exposed.

Meanwhile, the passivation layer 130 may be disposed on the cathode 153 as well as on the laser ablation area LA. The passivation layer 130 may extend to the non-active area NA. The passivation layer 130 may be disposed up to the end portion of the substrate 101 on which the scribe line CPS Line is formed, on the upper side of the display panel 310. Also, the passivation layer 130 may also be disposed within the trench T in the laser ablation area LA from which the capping layer, the cathode 153, and the organic layer 152 are removed.

The passivation layer 130 may be formed of silicon oxide (SiOx), silicon nitride (SiNx), or a multilayer thereof to retard moisture penetration, but the present disclosure is not limited thereto.

The adhesive layer 107 and the encapsulation substrate 309 may be disposed on the passivation layer 130. The adhesive layer 107 may be disposed on the passivation layer 130. The adhesive layer 107 may extend to a side surface of a dam 340. The encapsulation substrate 309 may be disposed on the adhesive layer 107.

The display panel 310 according to still another example embodiment of the present disclosure is characterized in that the color filter layer 308 is disposed on an upper surface of the encapsulation substrate 309. The color filter layer 308 may overlap the organic layer 152 (specifically, the light emitting layer within the organic layer 152) in the sub-pixel.

The color filter layer 308 may include a first color filter, a second color filter, and a third color filter. For example, the first color filter may include a green color filter overlapping a light emitting layer of a first sub-pixel, the second color filter may include a blue color filter overlapping a light emitting layer of a second sub-pixel, and the third color filter may include a red color filter overlapping a light emitting layer of a third sub-pixel.

In still another example embodiment of the present disclosure, a color of light output from the corresponding sub-pixel may be determined according to a color of the color filter included in the sub-pixel.

Although not shown in detail, the color filter layer 308 may be separated into a first color filter, a second color filter, and a third color filter by wall portions. The wall portions define areas of the color filter layer 308. For example, the wall portions may be disposed at boundaries of the color filters of the color filter layer 308, which have different colors. The wall portion may serve as a dam to prevent mixing of color filter inks when the color filter layer 308 is formed by a solution process using an inkjet device. To this end, the wall portion may include a hydrophobic polymer material.

The wall portion may be hydrophobic properties or hydrophilic properties. For example, at least a part of a surface of the wall portion may be formed to have hydrophobic properties. For example, the wall portion may be formed through a photolithography process after applying a solution obtained by mixing an organic insulating material with a hydrophobic material, such as fluorine (F). During the photolithography process, a hydrophobic material, such as fluorine, may move to an upper portion of the wall portion by irradiated light, and thus, an upper surface of the wall portion may have hydrophobic properties and a remaining portion thereof may have hydrophilic properties.

Meanwhile, in still another example embodiment of the present disclosure, the color filter layer 308 is removed in the reliable bezel area BA where the dam 340 is disposed.

The color filter layer 308 may be removed through a laser ablation process.

The dam 340 may be disposed between the substrate 101 and the encapsulation substrate 309 at the edge of the substrate 101. The dam 340 may be disposed in the non-active area NA outside the active area AA.

Meanwhile, in the non-active area NA on the upper side of the display panel 310, the laser ablation area LA is located in the reliable bezel area BA where the dam 340 is disposed. For example, the laser ablation area LA is located within the reliable bezel area BA and has a width smaller than that of the reliable bezel area BA. The dam 340 includes getter elements and may also be disposed within the trench T of the laser ablation area LA.

In still another example embodiment of the present disclosure, in the reliable bezel area BA, as the color filter layer 308 is removed therefrom, the dam 340 may contact the encapsulation substrate 309 at an upper portion thereof, contact the color filter layer 308 and the adhesive layer 107 at a side surface thereof, and may contact the passivation layer 130 at a lower portion thereof.

The example embodiments of the present disclosure can also be described as follows:

According to an aspect of the present disclosure, there is provided an electroluminescent display device. The electroluminescent display device comprises a substrate including an active area and a non-active area surrounding the active area, driving elements on the substrate, a planarization layer over the driving elements, an anode on the planarization layer, an organic layer on the anode and absent at a laser ablation area in the non-active area to surround the active area with a portion of the organic layer disposed outside the laser ablation area, a cathode on the organic layer and absent at the laser ablation area with a portion of the cathode disposed outside the laser ablation area, an encapsulation substrate above the substrate, and a dam at the laser ablation area between the substrate and the encapsulation substrate.

The organic layer is in the active area and the non-active area except for the laser ablation area, and the cathode may be in the active area and the non-active area except for the laser ablation area.

The electroluminescent display device may further include a trench through the planarization layer at the laser ablation area.

The planarization layer may include first and second planarization layer, and the trench may be formed through the second planarization layer to expose an upper surface of the first planarization layer.

The trench may be disposed in a direction parallel to an edge of the substrate (in the non-active area).

The trench may be disposed in a direction parallel to a boundary between adjacent the active area and the non-active area.

The electroluminescent display device may further include a bank disposed on the planarization layer adjacent to the trench.

The bank may include first and second bank portions on opposite sides of the trench.

The organic layer may further comprise an additional trench through the planarization layer at an edge of the laser ablation area, and an additional bank adjacent to the additional trench, wherein the organic layer is on the additional bank and in the additional trench, the organic layer being absent at portions of the additional trench within the laser ablation area.

The cathode may be disposed in the additional trench, and the cathode may be absent at the portions of the additional trench within the laser ablation area.

The laser ablation area may be an area from which the cathode and the organic layer are removed by irradiating a laser to a portion of the upper side of the non-active area.

A passivation layer may be provided over the cathode, the passivation layer may extend to an end portion of the substrate in the non-active area, and the passivation layer may be disposed in the trench.

The laser ablation area may be spaced apart from an edge of the substrate.

The dam may surround the active area on a plane view.

The electroluminescent display device may further include a color filter layer on the encapsulation substrate, and the color filter layer may be absent from an area where the dam is disposed.

In another aspect, an electroluminescent display device may comprise a substrate including an active area and a non-active area surrounding the active area; an anode over the substrate in at least the active area; an organic layer on the anode in at least the active area; and a cathode on the organic layer in at least the active area; wherein a laser ablation area is defined in the non-active area to surround the active area, wherein each of the organic layer and the cathode are absent in the laser ablation area, and wherein at least one of the organic layer and the cathode is disposed in the non-active area outside of the laser ablation area.

The organic layer may be in the active area and the non-active area except for the laser ablation area, and the cathode may be in the active area and the non-active area except for the laser ablation area.

The laser ablation area may be an area from which the cathode and the organic layer are removed by irradiating a laser to a portion of the upper side of the non-display area.

In another aspect, an electroluminescent display device comprises a substrate including an active area and a non-active area surrounding the active area; an anode on the substrate in at least the active area; an organic layer on the anode, the organic layer being divided into a first portion at least in the active area, and a second portion in the non-active area; a cathode on the organic layer being divided into two portions in the active area and in the non-active area, respectively, and a dam disposed in a laser ablation area which is disposed between the first and second portions of the organic layer.

The organic layer may be in the active area and the non-active area except for the laser ablation area and the cathode may be in the active area and the non-active area except for the laser ablation area.

It will be apparent to those skilled in the art that various modifications and variations can be made in the electroluminescent display device of the present disclosure without departing from the technical idea or scope of the disclosure. Thus, it is intended that the present disclosure cover the modifications and variations of this disclosure provided they come within the scope of the appended claims and their equivalents.

## Claims

1. An electroluminescent display device, comprising:
a substrate (101) including an active area (AA) and a non-active area (NA) surrounding the active area (AA);
a planarization layer (105) over the substrate (101);
an anode (151) on the planarization layer (105);
an organic layer (152) on the anode (151) and absent at a laser ablation area (LA) in the non-active area (NA) to surround the active area (AA), a portion of the organic layer (152) disposed outside the laser ablation area (LA);
a cathode (153) on the organic layer (152) and absent at the laser ablation area (LA), a portion of the cathode (153) disposed outside the laser ablation area (LA);
an encapsulation substrate (109, 309) above the substrate (101); and
a dam (140, 240, 340) at the laser ablation area (LA) between the substrate (101) and the encapsulation substrate (109, 309).

2. The electroluminescent display device of claim 1, wherein the organic layer (152) is in the active area (AA) and the non-active area (NA) except for the laser ablation area (LA), and
wherein the cathode (153) is in the active area (AA) and the non-active area (NA) except for the laser ablation area (LA).

3. The electroluminescent display device of claim 1 or 2, further comprising a trench (T) through the planarization layer (105) at the laser ablation area (LA).

4. The electroluminescent display device of claim 3, wherein the planarization layer (105) includes a first planarization layer (105a) and a second planarization layer (105b), and
wherein the trench (T) is formed through the second planarization layer (105b) to expose an upper surface of the first planarization layer (105a).

5. The electroluminescent display device of claim 3, or 4 wherein the trench (T) is disposed in a direction parallel to an edge of the substrate (101) in the non-active area (NA).

6. The electroluminescent display device of claim 5, wherein the trench (T) is disposed in the direction parallel to a boundary between the active area (AA) and the non-active area (NA).

7. The electroluminescent display device of any one of claims 3 to 6, further comprising a bank (106) disposed on the planarization layer (105) adjacent to the trench (T).

8. The electroluminescent display device of claim 7, wherein the bank (106) includes first and second bank portions disposed on opposite sides of the trench (T).

9. The electroluminescent display device of claim 7 or 8, further comprising an additional trench (T') through the planarization layer (105) at an edge of the laser ablation area (LA), and an additional bank adjacent to the additional trench (T'),
wherein the organic layer (152) is on the additional bank and in the additional trench (T'), the organic layer (152) being absent at portions of the additional trench (T') within the laser ablation area (LA).

10. The electroluminescent display device of claim 9, wherein the cathode (153) is disposed in the additional trench T', the cathode (153) being absent at the portions of the additional trench (T') within the laser ablation area (LA).

11. The electroluminescent display device of any one of claims 1 to 10, wherein the laser ablation area (LA) is an area from which the cathode (153) and the organic layer (152) are removed by irradiating a laser to a portion of the upper side of the non-active area.

12. The electroluminescent display device of any one of claims 3 to 10, further including a passivation layer (130) over the cathode (153), wherein the passivation layer (130) extends to an end portion of the substrate (101) in the non-active area (NA), and
wherein the passivation layer (130) is in the trench (T).

13. The electroluminescent display device of any one of claims 1 to 12, wherein the laser ablation area (LA) is spaced apart from an edge of the substrate (101).

14. The electroluminescent display device of any one of claims 1 to 13, wherein the dam (140, 240, 340) surrounds the active area (AA) on a plane view.

15. The electroluminescent display device of any one of claims 1 to 14, further comprising a color filter layer (308) on the encapsulation substrate (309),
wherein the color filter layer is absent from an area where the dam (340) is disposed.
